Europäisches Patentamt

European Patent Office

Office européen des brevets

(11) Publication number: **0 549 567 A2**

## EUROPEAN PATENT APPLICATION

(21) Application number: **93103501.8**

(22) Date of filing: **16.07.90**

(51) Int. Cl.5: **H01L 39/24**

This application was filed on 04 - 03 - 1993 as a divisional application to the application mentioned under INID code 60.

(30) Priority: **19.07.89 JP 188597/89**

(43) Date of publication of application:
**30.06.93 Bulletin 93/26**

(60) Publication number of the earlier application in accordance with Art.76 EPC: **0 409 150**

(84) Designated Contracting States:
**DE FR GB**

(71) Applicant: **SUMITOMO ELECTRIC INDUSTRIES, LIMITED**
**5-33, Kitahama 4-chome Chuo-ku**
**Osaka(JP)**

(72) Inventor: **Mukai, Hidehito, c/o Osaka Works of Sumitomo**
**Elec. Ind., Ltd, 1-3, Shimaya 1-chome, Konohana-ku**
**Osaka(JP)**
Inventor: **Sato, Ken-ichi, c/o Osaka Works of Sumitomo**
**Elec. Ind., Ltd, 1-3, Shimaya 1-chome, Konohana-ku**
**Osaka(JP)**

(74) Representative: **KUHNEN, WACKER & PARTNER**
**Alois-Steinecker-Strasse 22 Postfach 1553**
**W-8050 Freising (DE)**

(54) **Superconducting wire.**

(57) A superconducting wire comprises an oxide superconductor member and a metal layer provided around the oxide superconductor member. The ratio of the sectional area of the metal layer to that of the oxide superconductor member is at least 0.2 and not more than 1.0.

FIG.1

BACKGROUND OF THE INVENTION

Field of the Invention

The present invention relates to superconducting wire, which can be applied to a current-carrying lead for a superconducting magnet, for example.

Description of the Background Art

In general, a current-carrying lead for a superconducting magnet, which is used at a temperature of 4.2 K, is formed of a copper pipe which is mainly composed of copper etc. Such a current-carrying lead is adapted to carry a current from an ordinary temperature region to a liquid helium temperature region. In such a current-carrying lead, however, heat is inevitably generated by specific resistance of copper, and a large quantity of helium is consumed upon energization.

In order to solve such a problem, the current-carrying lead may be formed of an oxide superconductor which exhibits superconductivity at a high temperature, to suppress heat generation upon energization.

However, even if the current-carrying lead is thus formed of an oxide superconductor to suppress heat generation upon energization, helium is still problematically consumed by conduction of heat from the ordinary temperature region to the liquid helium temperature region in a non-energized state.

SUMMARY OF THE INVENTION

An object of the present invention is to provide superconducting wire, which can reduce consumption of liquid helium when the superconducting wire is applied to a current lead, for example.

The inventive superconducting wire is characterized in that a metal layer is provided around an oxide superconductor member so that the ratio (hereinafter referred to as "metal ratio") of the sectional area of the metal layer to that of the oxide superconductor is at least 0.2 and not more than 1.0.

According to the present invention, the metal ratio is at least 0.2 since plastic working of the superconducting wire is impractically made difficult if the metal ratio is less than 0.2. Further, the metal ratio is not more than 1.0 since the quantity of heat transferred through the metal layer is so increased that the object of the present invention cannot be attained if the metal ratio exceeds 1.0.

A superconducting wire comprising an oxide superconductor member and a metal layer provided around the same can be produced by charging raw material powder for the oxide superconductor member in a metal pipe and performing plastic working and heat treatment on the raw material powder, for example. In order to attain a metal ratio which satisfies a value defined by the present invention in this method, it is necessary to appropriately select the outer and inner diameters of the metal pipe. If the metal ratio is larger than the value defined by the present invention, the metal layer can be partially removed by etching or the like, to bring the metal ratio into a range defined in the present invention.

The oxide superconductor employed in the present invention is not particularly restricted but may be prepared from a bismuth superconductor which is composed of Bi, Pb, Sr, Ca, Cu and O, for example.

A known example of such a bismuth superconductor is an oxide superconductor which has composition ratios of $Bi_aPb_bSr_cCa_dCu_e$, where a + b : c : d : e = 1.7 to 2.8 : 1.7 to 2.5 : 1.7 to 2.8 : 3, for example.

The inventive superconducting wire can be produced by a method of charging raw material powder for an oxide superconductor in a metal pipe and performing plastic working and heat treatment on the raw material powder to work the same into wire, for example, while heat treatment for preparing the raw material powder is preferably carried out in a decompressed atmosphere of the air.

It is preferable that the raw material powder is repeatedly subjected to plastic working and heat treatment at least twice in the form of wire.

When the oxide superconductor is prepared from a bismuth superconductive material, the metal layer is preferably formed of silver or silver alloy.

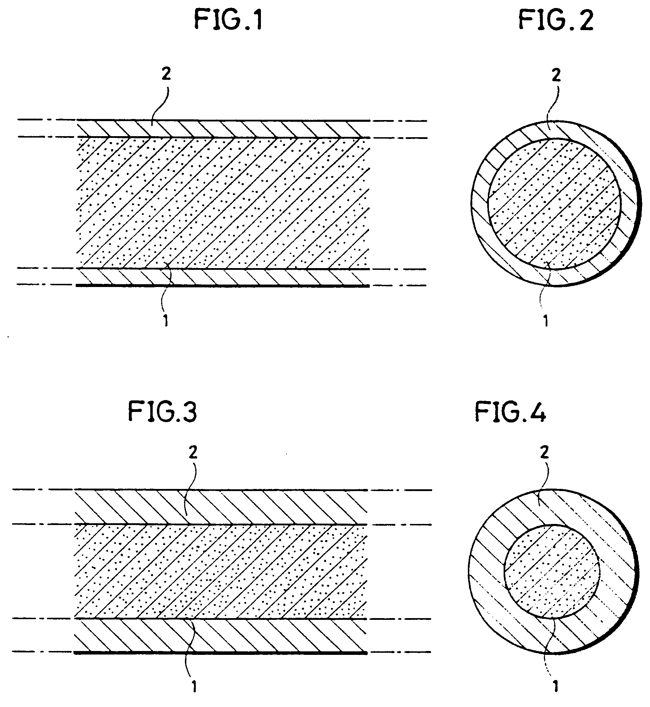

Fig. 1 is a longitudinal sectional view showing an embodiment of the present invention, and Fig. 2 is a cross sectional view thereof. As shown in Figs. 1 and 2, a metal layer 2 is provided around an oxide superconductor member 1, so that the ratio of the sectional area of the metal layer 2 to that of the oxide superconductor member 1, i.e., the metal ratio, is at least 0.2 and not more than 1.0.

Fig. 3 is a longitudinal sectional view showing an example of conventional superconducting wire, and Fig. 4 is a cross sectional view thereof. In the conventional superconducting wire, the ratio of the sectional area of a metal layer 2 to that of an oxide superconductor member 1 is in excess of 1.0, as shown in Figs. 3 and 4.

2

EP 0 549 567 A2

According to the present invention, the metal ratio is small as shown in Figs. 1 and 2 so that the sectional area of the metal layer 2 is smaller than that of the oxide superconductor member 1, whereby the quantity of heat transferred through the metal layer 2 into a cooling medium is reduced. Thus, it is possible to reduce consumption of the cooling medium such as liquid helium.

These and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a longitudinal sectional view showing an embodiment of the present invention;

Fig. 2 is a cross sectional view showing the embodiment of the present invention;

Fig. 3 is a longitudinal sectional view showing an example of conventional superconducting wire;

Fig. 4 is a cross sectional view showing the example of the conventional superconducting wire;

Fig. 5 is a sectional view showing an apparatus for measuring the quantities of liquid helium consumed when oxide superconducting wires produced according to the present invention are applied to current-carrying leads;

Fig. 6 is a sectional view showing a connected portion between a copper pipe and each oxide superconducting wire in the apparatus shown in Fig. 5; and

Fig. 7 is a sectional view showing a connected portion between each oxide superconducting wire and a metal superconducting wire in the apparatus shown in Fig. 5.

DESCRIPTION OF THE PREFERRED EMBODIMENTS

Raw material powder was prepared by mixing $Bi_2O_3$, PbO, $SrCO_3$, $CaCO_3$ and CuO so that Ba, Pb, Sr, Ca and Cu were in the ratios 1.8:0.4:2:2.2:3. The raw material powder was sintered twice in the atmospheric air at 750 to 850°C and thereafter sintered at 760°C under decompressed air of 1 Torr. Samples of the sintered powder were charged in silver pipes having dimensions/configurations shown in Table 1 respectively, drawn into wires of 2 mm in diameter, then rolled to be 0.7 mm in thickness, thereafter sintered at 845°C for 50 hours, further subjected to cold rolling and finally sintered at 840°C for 50 hours.

Table 1 also shows the metal ratios and critical current density values of the as-formed wires. It was impossible to perform plastic working on reference example 5.

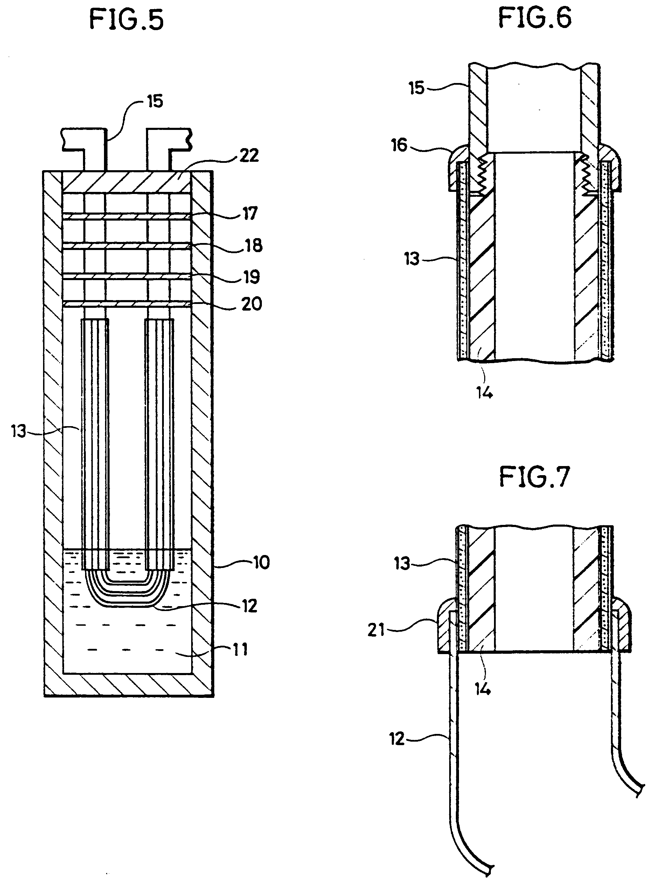

Then the superconducting wires were experimentally applied to current-carrying leads. Fig. 5 is a sectional view showing an apparatus which was employed for measuring the quantities of liquid helium consumed in relation to the current-carrying leads prepared from the aforementioned superconducting wires. Referring to Fig. 5, liquid helium 11 is contained in a lower part of a cryostat 10 serving as a vessel, and metal superconducting wires 12 are dipped in the liquid helium 11. Oxide superconducting wires 13 are connected to both ends of the metal superconducting wires 12, and copper pipes 15 are connected to upper ends of the oxide superconducting wires 13. These copper pipes 15 project from the upper portion of the cryostat 10 to the exterior, which is at the room temperature. A lid 22 is mounted on the upper portion of the cryostat 10. Four FRP plates 17, 18, 19 and 20 are arranged in the upper part of the cryostat 10, in order to shield the apparatus against heat. The copper pipes 15 pass through the FRP plates 17 to 20 and project to the exterior of the cryostat 10.

Fig. 6 is a sectional view showing a connected portion between each copper pipe 15 and each oxide superconducting wire 13 in the apparatus shown in Fig. 5. Referring to Fig. 6, a female screw is formed inside the lower end of the copper pipe 15, and a male screw formed on an FRP pipe 14 is engaged with the female screw. The oxide superconducting wire 13, which is in the form of a tape, is mounted around the FRP pipe 14. This oxide superconducting wire 13 is electrically connected with the copper pipe 15 by solder 16.

Fig. 7 is a sectional view showing a connected portion between each oxide superconducting wire 13 and each metal superconducting wire 12 in the apparatus shown in Fig. 5. Referring to Fig. 7, an end of the metal superconducting wire 12 is mounted on the oxide superconducting wire 13, which is mounted along the outer periphery of the FRP pipe 14, by solder 21. The oxide superconducting wire 13 is electrically connected with the metal superconducting wire 12 by the solder 21.

A plurality of oxide superconducting wires 13 are mounted around the FRP pipe 14, so that the critical currents thereof are 1000 A. In the apparatus shown in Fig. 5, the temperature of the region provided with the oxide superconducting wires 13 is not more than 80 K.

3

The apparatus shown in Fig. 5 was used to measure the quantities of liquid helium consumed when Examples 1 and 2 and reference examples 3 and 4 shown in Table 1 were applied to current-carrying leads. The measurement was performed with a current of 500 A. In each sample, an aggregate of the oxide superconducting wires was prepared in a length of 50 cm and critical current density was defined by voltage generation of 1 $\mu$V with a distance of 40 cm between voltage terminals, while consumption of liquid helium was expressed in a relative ratio to the quantity of liquid helium consumed when a conventional current-carrying lead of a copper pipe was energized with a current of 500 A in current density of 1500 A/cm$^2$. The critical current density of the metal superconducting wires 12 was 300000 A/cm$^2$.

As clearly understood from the results shown in Table 1, the quantities of liquid helium consumed in relation to the superconducting wires of Examples 1 and 2 according to the present invention were extremely smaller than those of reference examples 3 and 4.

Table 1

| | No. | Silver Pipe (mm $\phi$) | | Metal Ratio | Critical Current Density (A/cm$^2$) | Helium Consumption |
|---|---|---|---|---|---|---|
| | | Outer Diameter | Inner Diameter | | | |
| Example | 1 | 12 | 10 | 0.80 | 6320 | 0.5 |
| | 2 | 12 | 11 | 0.23 | 5980 | 0.3 |
| Reference Example | 3 | 12 | 8 | 2.3 | 5500 | 2.2 |
| | 4 | 12 | 9.5 | 1.1 | 6300 | 1.7 |
| | 5 | 12 | 11.2 | 0.15 | Plastic Working Inavailable | |

According to the present invention, as hereinabove described, the ratio of the sectional area of the metal layer to that of the oxide superconductor member is made to satisfy a prescribed value to reduce the quantity of heat transferred through the metal layer, thereby reducing the quantity of liquid helium consumed by thermal conduction.

Although the present invention has been described and illustrated in detail, it is clearly understood that the same is by way of illustration and example only and is not to be taken by way of limitation, the spirit and scope of the present invention being limited only by the terms of the appended claims.

Table 1A

| | No. | Silver Pipe (mm φ) | | | Reduction in Cross Sectional Area of Superconductor | Final Silver Ratio |
|---|---|---|---|---|---|---|
| | | Initial Outer Diameter | Initial Inner Diameter | Initial Silver Ratio | | |
| Example | 1 | 12 | 10 | 0.44 | 0.55 | 0.88 |
| | 2 | 12 | 11 | 0.19 | 0.83 | 0.23 |
| Reference Example | 3 | 12 | 8 | 1.25 | 0.54 | 2.3 |
| | 4 | 12 | 9.5 | 0.60 | 0.54 | 1.1 |
| | 5 | 12 | 11.2 | 0.15 | Plastic Working Inavailable | |

The metal ratio mentioned in claim 1 and shown in Table 1 in the specification indicates the ratio of the sectional area of the metal sheath to that of the oxide superconductor in the state of the final product. On the other hand, the dimensions of the silver pipe in Table 1 indicate the initial ones before the silver pipe containing the superconductor powder is deformed plastically. Table 1A, which is a modification of Table 1, is appended hereto. The cross sectional reduction ratio of the oxide superconductor depends on the initial packing density of the superconductor powder in the metal sheath and the method of the plastic deformation of the metal sheath and the method of the plastic deformation of the metal sheath containing the oxide superconductor. Most of the samples show about 55 % reduction in the cross sectional area, but only sample No. 2 having a small initial silver ratio of 0.19 shows a rather large value of 83 %.

5

**Claims**

1.  A method of manufacturing a superconducting wire comprising the steps of charging into a metal sheath powders having composition ratios expressed as $Bi_aPb_bSr_cCa_dCu_e$ where $(a+b):c:d:e: = 1.7$ to $2.8:1.7$ to $2.5:1.7$ to $2.8:3$, plastically elongating said metal sheath with said powders, rolling said sheath into a tape-like shape, sintering said powders to convert them into aggregated superconductor crystals characterized in further rolling said sheath in order to more densely aggregate said superconductor crystals, and sintering said superconductor crystals more tightly, whereby the ratio of the sectional area of said metal sheath to that of said superconductor becomes at least 0.2 and not more than 1.0.

2.  A method of manufacturing a superconducting wire in accordance with claim 1, wherein said metal sheath is made of silver or silver alloy.

## FIG.1

## FIG.2

## FIG.3

## FIG.4

# FIG.5

# FIG.6

# FIG.7